# EUROPEAN PATENT SPECIFICATION

(11) **EP 4 496 107 B1**
(45) Date of publication and mention of the grant of the patent: **13.05.2026**
(21) Application number: 24188502.9
(22) Date of filing: 15.07.2024
(51) Int. Cl.: H01M 50/505, H01M 50/519, H01M 50/528, H05K 1/18

(54) **RECHARGEABLE BATTERY MODULE**
WIEDERAUFLADBARES BATTERIEMODUL
MODULE DE BATTERIE RECHARGEABLE

(30) Priority: 21.07.2023 KR 20230095514
(43) Date of publication of application: 22.01.2025
(73) Proprietor: SAMSUNG SDI CO., LTD., Giheung-gu Yongin-si, Gyeonggi-do 17084 (KR)
(72) Inventor: Lee, Hyeok, 17084 Yongin-si, Gyeonggi-do (KR); Kwon, Young-Hwan, 17084 Yongin-si, Gyeonggi-do (KR)
(74) Representative: Gulde & Partner

(56) References cited:
- WO-A1-2018/124751
- US-A- 4 851 613

## Description

### BACKGROUND OF THE INVENTION

### (a) Field of the Invention

The present disclosure relates to a rechargeable battery module, and more particularly, to a rechargeable battery module that connects a sensing portion of a flexible printed circuit (FPC) to a busbar.

### (b) Description of the Related Art

Unlike primary batteries, rechargeable batteries are batteries that can be repeatedly charged and discharged. Small-capacity rechargeable batteries are used in small, portable electronic devices such as mobile phones, laptop computers, and camcorders.

High-capacity and high-density secondary batteries are used as power sources for driving motors in hybrid and electric vehicles or for energy storage. The rechargeable batteries may be used by forming a rechargeable battery module including a plurality of battery cells connected in series and/or parallel to drive a motor of, for example, a hybrid vehicle that requires relatively high energy density.

The rechargeable battery module is equipped with a flexible printed circuit (FPC) that detects a voltage or current from the busbar and transmits a detection signal. The FPC sensing structure solders the FPC to a separate nickel tab (Ni-Tab) and welds the tab to an aluminum (Al) busbar.

Nickel tabs (Ni- tab), however, are associated with increased costs because they require raw nickel, a soldering process to form junctions, a coating process to form an anticorrosion coating, and jigs for guides.

Deformation (e.g., S deform) of the FPC causes sagging during movement due to the nickel tab. Such sagging in FPC can occur during the welding of the aluminum busbar and the nickel tab It is therefore difficult to form the in-position junction of the FPC and the nickel tab for the busbar. Examples may be found in WO 2018/124751 A1.

### SUMMARY OF THE INVENTION

The present disclosure provides a rechargeable battery module capable of directly bonding of a flexible printed circuit (FPC) to a busbar. The present disclosure also provides a rechargeable battery module that enables in-position junction of the flexible printed circuit (FPC) to the busbar.

A rechargeable battery module according to an embodiment of the present disclosure includes: a busbar holder covering a plurality of battery cells, a busbar disposed on the busbar holder to electrically connect the battery cells; and a flexible printed circuit (FPC) attached to the busbar for sending a signal and detecting a current in the busbar, wherein the flexible printed circuit includes a thin copper film attached between the inner surfaces of a pair of cover layers, wherein the thin copper film is exposed in (each of a plurality of) unit thin film portions through a plurality of openings formed in the pair of cover layers, the thin copper film and the pair of cover layers are bent, and the unit thin film portions are formed in multiple layers (e.g. the unit thin film portions form multiple layers) and welded to the busbar.

The unit thin film portion has a thickness of 0.035 mm, and the total thickness of the multiple layers is equal to 0.035 mm multiplied by the number of layers.

The flexible printed circuit includes: a main line portion disposed in a first direction on the busbar holder; and a branch line portion protruding from the main line portion in a second direction intersecting the first direction, and disposed further in the first direction. The unit thin film portions may be connected to the branch line portion.

The branch line portion is attached to the busbar.

In some embodiments, the rechargeable battery module has two unit thin film portions connected in the first direction.

The unit thin film portions may include a first unit portion and a second unit portion continuously extending along the first direction, and the first unit portion and the second unit portion may be bent and overlapped with each other around a second direction bending axis set in the second direction.

The first unit portion may include a first plane portion connected to a first inclined portion at a first inclined angle θ1, the second unit portion may include a second plane portion connected to a second inclined portion at a second inclined angle θ2 that is greater than the first inclined angle, and the first plane portion and the second plane portion may be connected in the second direction, sequentially stacked on the busbar, and welded to the busbar.

In some embodiments, the rechargeable battery module has two unit thin film portions connected in the second direction.

The unit thin film portions may include a first unit portion and a second unit portion continuously extending along the second direction, and the first unit portion and the second unit portion may be bent and overlapped with each other around a first direction bending axis set in the first direction.

The first unit may include a first plane portion connected to the first inclined portion at a first inclination angle θ21, the second unit portion may include the second plane portion connected to the second inclined portion at a second inclined angle θ22 that is greater than the first inclined angle, and the first plane portion and the second plane portion may be connected in the first direction, sequentially stacked on the busbar, and welded to the busbar.

In some embodiments, the rechargeable battery module has three unit thin film portions connected in the second direction.

The unit thin film portions may include a first unit portion, a second unit portion and a third unit portion continuously extending along the second direction, wherein the first unit portion and the second unit portion may be bent and overlapped with each other around a first direction bending axis set in the first direction, and the second unit portion and the third unit portion may be bent and overlapped with each other around another first direction bending axis set in the first direction.

The first unit portion may include the first plane portion connected to the first inclined portion at a first inclined angle θ31, the second unit portion may include the second plane portion connected to the second inclined portion at a second inclined angle θ32 that is greater than the first inclined angle, the third unit portion may include a third plane portion connected to a third inclined portion at a third inclined angle θ33 greater than the second inclined angle, and the first plane portion, the second plane portion, and the third plane portion may be connected in the second direction, sequentially stacked on the busbar, and welded to the busbar.

In some embodiments, the rechargeable battery module has three unit thin film portions connected in the first direction.

The unit thin film portions may include a first unit portion, a second unit portion and a third unit portion continuously extending along the first direction, wherein the first unit portion and the second unit portion may be bent and overlapped with each other around a second direction bending axis set in the second direction, and the second unit portion and the third unit portion may be bent and overlapped with each other around another second direction bending axis set in the second direction.

The unit thin film portions may include a first unit portion, a second unit portion, a third unit portion and a fourth unit portion continuously extending along the first direction, wherein the first unit portion and the second unit portion may be bent and overlapped with each other around a second direction bending axis set in the second direction, the second unit portion and the third unit portion may be bent and overlapped with each other around another second direction bending axis set in the second direction, and the third unit portion and the fourth unit portion may be bent and overlapped with each other around the other second direction bending axis set in the second direction.

In some embodiments, the rechargeable battery module has four unit thin film portions connected in the first direction and the second direction.

The unit thin film portions may include a first unit portion and a second unit portion continuously extending along the first direction, and a third unit portion and a fourth unit portion continuously extending along the second direction to the first unit portion and the second unit portion, and continuously extending along the first direction.

According to the above described embodiments of the rechargeable battery module, the thin copper film is exposed in the unit thin film portions through a plurality of openings formed in the cover layer, the thin copper film and the cover layer are bent (e.g. folded), and therefore the unit thin film portions form multiple layers and are welded to the busbar made of aluminum.

The embodiments allow direct bonding a flexible printed circuit (FPC) and a busbar made of aluminum. Additionally, according to the variety of arrangements of the unit thin film portions in the embodiments, it is possible to bond the flexible printed circuit (FPC) to the busbar in the desired position.

Another aspect, which does not fall under the protection scope of the present disclosure, relates to a flexible printed circuit for a rechargeable battery module as described above, configured to send a signal and to detect a current. The flexible printed circuit comprises a thin copper film attached between inner surfaces of a pair of cover layers, the thin copper film being exposed in unit thin film portions through a plurality of openings formed in the pair of cover layers, wherein the thin copper film and the pair of cover layers are foldable (e.g. bendable), and the unit thin film portions are configured to form multiple overlapping layers.

### BRIEF DESCRIPTION OF THE DRAWINGS

FIG. 1 is a partial cross-sectional view of a rechargeable battery module according to a first embodiment of the present disclosure.
FIG. 2 is a perspective view of a busbar, a flexible printed circuit, and a unit thin film portion of FIG. 1 before bending (e.g. folding).
FIG. 3 is a perspective view of the unit thin film portion of FIG. 2 during bending (e.g. folding).
FIG. 4 is a top plan view of the unit thin film portion of FIG. 2 in a completed state of bending (e.g. folding).
FIG. 5 is a cross-sectional view taken along line V-V of the unit thin film portions of FIG. 4 bent (folded) over each other and arranged on a busbar.
FIG. 6 is a cross-sectional view taken along line V-V of the unit thin film portions of FIG. 5 welded on a busbar.
FIG. 7 is a top plan view of the busbar, flexible printed circuit, and unit thin film portion in the rechargeable battery module according to the second embodiment of the present disclosure before bending (e.g. folding).
FIG. 8 is a top plan view of the unit thin film portion of FIG. 7 in a completed state of bending (e.g. folding).
FIG. 9 is a cross-sectional view taken along line IX-IX of the unit thin film portions of FIG. 8 bent (folded) over each other and arranged on a busbar.
FIG. 10 is a cross-sectional view taken along line IX-IX of the unit thin film portions of FIG. 8 welded on a busbar.
FIG. 11 is a perspective view of the busbar, flexible printed circuit, and unit thin film portion in the rechargeable battery module according to the third embodiment of the present disclosure before bending (e.g. folding).
FIG. 12 is a perspective view of the unit thin film portion of FIG. 11 in a completed state of bending (e.g. folding).
FIG. 13 is a cross-sectional view taken along line XIII-XIII of the unit thin film portions of FIG. 12 bent (folded) over each other and arranged on a busbar.
FIG. 14 is a cross-sectional view taken along line XIII-XIII of the unit thin film portions of FIG. 12 welded on a busbar.
FIG. 15 is a top plan view of the busbar, flexible printed circuit, and unit thin film portion in the rechargeable battery module according to the fourth embodiment of the present disclosure before bending (e.g. folding).
FIG. 16 is a perspective view of the primary and secondary bending states of the flexible printed circuit and the unit thin film portion in the rechargeable battery module according to the fifth embodiment of the present disclosure.
FIG. 17 is a perspective view of the unit thin film portion of FIG. 16 in the tertiary bending state, which corresponds to a complete state of bending (e.g. folding).
FIG. 18 is a top plan view of the busbar, flexible printed circuit, and unit thin film portion in the rechargeable battery module according to the sixth embodiment of the present disclosure before bending (e.g. folding).

### DETAILED DESCRIPTION OF THE EMBODIMENTS

Hereinafter, the present disclosure will be described more fully with reference to the accompanying drawings, in which exemplary embodiments of the invention are shown. As those skilled in the art will realize, the described embodiments may be modified in various different ways, all without departing from the scope of the invention as defined by the appended claims. The drawings and description are to be regarded as illustrative in nature and not restrictive. Like reference numerals designate like elements throughout the specification.

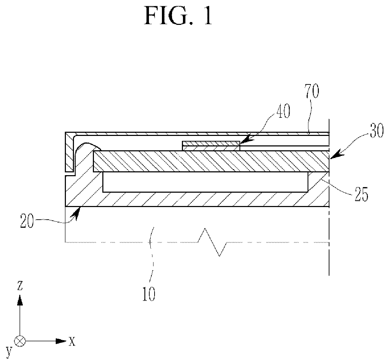

FIG. 1 is a partial cross-sectional view of a rechargeable battery module according to a first embodiment of the present disclosure. Referring to FIG. 1, the rechargeable battery module of the first embodiment includes a plurality of battery cells 10 formed of rechargeable batteries, a busbar holder 20, a busbar 30, and a flexible printed circuit (FPC) 40.

The rechargeable battery module of the first embodiment may have module frames of various structures, but detailed description of this configuration will be omitted and will be described as an example. A plurality of battery cells 10 are formed as rechargeable batteries and are stacked in a first direction (x-axis direction).

A pair of end plates is disposed on both ends of the stacked battery cells 10 in the first direction to constrain the battery cells 10 in the first direction (x-axis direction). A pair of side plates are disposed on both sides of the second direction (y-axis direction) of the battery cells 10 intersecting the first direction, and are connected to a pair of end plates to constrain the battery cells 10 in the second direction.

The battery cells 10 may be disposed in one or two rows. When disposed in two rows, an additional center plate may be disposed between a pair of side plates. The center plate is disposed in the first direction between the two rows of battery cells 10 to constrain the battery cells 10 in the second direction on both sides.

The busbar holder 20 may include a busbar support 25 for connecting and insulating the electrode terminals (not shown) of the battery cells 10, and a vent portion for discharging vent gas of the battery cells 10 (not shown).

The busbar support 25 exposes the electrode terminals in the third direction (height of the battery cell, z-axis direction) to cover the other portions of the battery cells 10 while supporting the busbar 30 that connects the electrode terminals in series or parallel. The third direction (height of the battery cell, z-axis direction) intersects the first direction (thickness of the battery cell, x-axis direction) and the second direction (length of the battery cell, y-axis direction).

The flexible printed circuit (FPC) 40 is configured to be attached to the busbar 30, to detect a current flowing in the busbar 30 that electrically connects the battery cells 10, and to send a detection signal to the battery management system (BMS).

The rechargeable battery module of the first embodiment may further include a top cover 70. The top cover 70 is disposed on the busbar 30, and is coupled to the busbar holder 20 from the outside to cover a plurality of busbars (not shown) and the busbar holder 20.

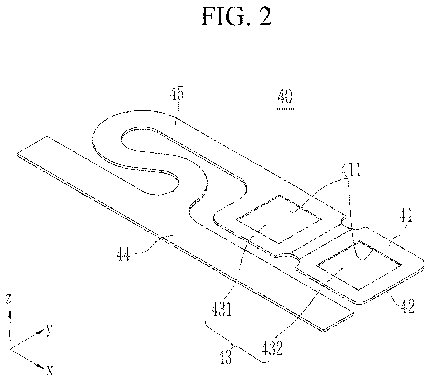

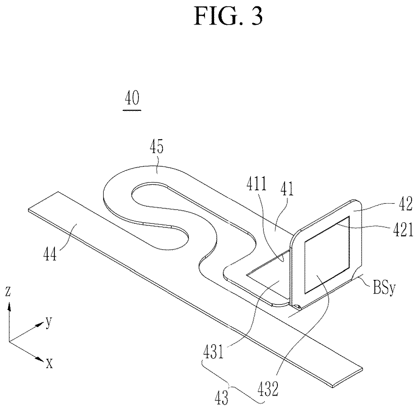

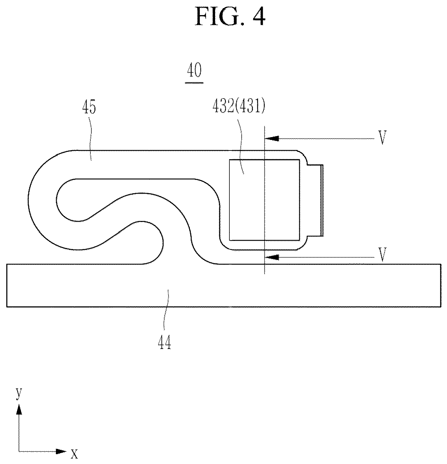

FIG. 2 is a perspective view of a busbar, a flexible printed circuit, and a unit thin film portion of FIG. 1 before bending (e.g. before folding), FIG. 3 is a perspective view of the unit thin film portion of FIG. 2 during bending (e.g. during folding), and FIG. 4 is a top plan view of the unit thin film portion of FIG. 2 in a completed state of bending (e.g. completed state of folding).

Referring to FIGS. 2 to 4, the flexible printed circuit 40 is formed by providing a thin copper film between the inner surfaces of a pair of cover layers 41 and 42 attached to each other. The thin copper film is exposed in (a plurality of) unit thin film portions 43 (e.g. a first unit thin film portion 431 and a second unit thin film portion 432) through a plurality of openings 411 and 421 formed in the cover layers 41 and 42. In other words, the (first) cover layer 41 comprises a plurality of openings 411 formed therein and the (second) cover layer 42 comprises plurality of openings 412 formed therein. Each of the unit thin film portions 43 comprise one opening in the cover layer 42 and the cover layer 43. The thin copper film, which is disposed between the pair of cover layers 41 and 42, is accessible through the plurality of openings 411 and 421 in both cover layers 41 and 42. Thus each of the unit thin film portions 43 comprises a part of the thin copper film accessible through the plurality of openings 411 and 421.

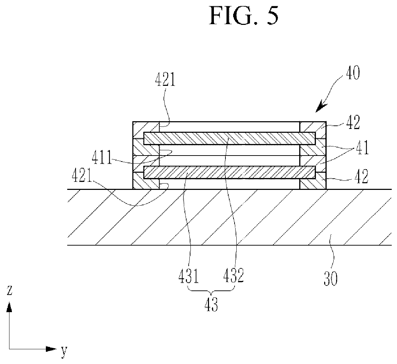

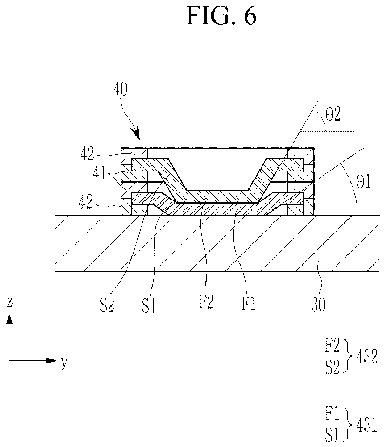

FIG. 5 is a cross-sectional view taken along line V-V of the unit thin film portions of FIG. 4 bent (folded) over each other and arranged on a busbar, and FIG. 6 is a cross-sectional view taken along line V-V of the unit thin film portions of FIG. 5 welded on a busbar.

Referring to FIGS. 5 and 6, the thin copper film and the cover layers 41 and 42 are bent (e.g. folded), and therefore the unit thin film portions 43 form multiple layers (e.g. multiple overlapping layers of unit thin film portions 43) and are welded to the busbar 30 made of aluminum. In this way, the multiple layers of unit thin film portions 43 (i.e. the multiple overlapping layers of unit thin film portions 43 resulting from folding the thin copper film and the cover layers 41 and 42) enable and strengthen the welding between dissimilar materials such as copper and aluminum.

Since the flexible printed circuit 40 does not use nickel tabs, the flexible printed circuit 40 does not significantly deform and sag during movement. Therefore, the multiple layers of unit thin film portions 43 facilitates in-position junction of the flexible printed circuit 40 and the busbar 40.

Since the unit thin film portion 43 has a thickness of 0.035 mm, the total thickness of the multiple layers is equal to 0.035 mm multiplied by the number of layers.

In the first embodiment, the two-layer unit thin film portions 43 have a thickness of 0.07 mm, which is twice that of 0.035 mm.

Since the two-layer unit thin portions 43 formed by bending (e.g. folding) have improved mechanical strength compared to the one-layer structure, it is possible to effectively prevent tearing, piercing during welding, and pinhole failure during movement and handling, for direct junction to the aluminum busbar 30.

Referring again to FIGS. 2 to 4, the flexible printed circuit 40 includes a main line portion 44 and a branch line portion 45. The main line portion 44 is disposed on the busbar holder 20 in the first direction (x-axis direction). The branch line portion 45 is connected to and protrudes from the main line portion 44 in the second direction (y-axis direction) intersecting the first direction and is disposed further in the first direction.

The unit thin film portions 43 are parts joined to the busbar 30 and are connected to the branch line portion 45. The branch line unit 45 is disposed corresponding to the busbar 30. In the first embodiment, there are two unit thin film portions 43 that are connected in the first direction (x-axis direction).

The unit thin film portions 43 include a first unit portion 431 and a second unit portion 432 that continuously extend along the first direction (x-axis direction). The first unit portion 431 and the second unit portion 432 are bent (e.g. folded) and overlapped with each other around a second direction bending axis BSy (folding axis) set in the second direction (y-axis direction).

Referring again to FIGS. 5 and 6, in the welded state, the first unit portion 431 includes a first plane portion F1 connected to a first inclined portion S1 at the first inclined angle θ1, and the second unit portion 432 includes a second plane portion F2 connected to a second inclined portion S2 at a second inclined angle θ2 that is greater than the first inclined angle θ1.

The first plane portion F1 and the second plane portion F2 are connected in the second direction (y-axis direction), are sequentially stacked on the busbar 30, and are welded to the busbar 30. Compared to a one-layer structure, the first plane portion F1 and the second plane portion F2 forming a two-layer structure may effectively prevent piercing and pinhole defects during welding. And the current signal of the bus bar 30 is transmitted to the branch line portion 45 and the main line portion 44 via the first inclined portion S1 and the second inclined portion S2 through the welded first plane portion F1 and the second plane portion F2.

In the flexible printed circuit 40 of the first embodiment, compared to the main line portion 44, the branch line portion 45 and the unit thin film portions 43 generate scrap on both sides of the x-axis direction. The flexible printed circuit 40 of the first embodiment allows the formation of unit thin film portions 43 while minimizing the generation of such scrap.

Hereinafter, various embodiments of the present disclosure will be described. Compared to the first embodiment and the previously described embodiments, descriptions of the same components will be omitted and descriptions of different components will be described.

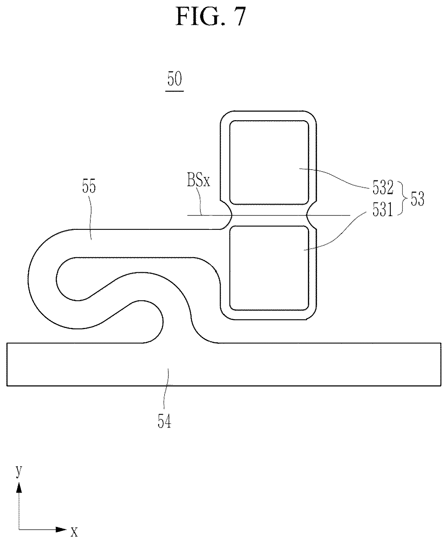

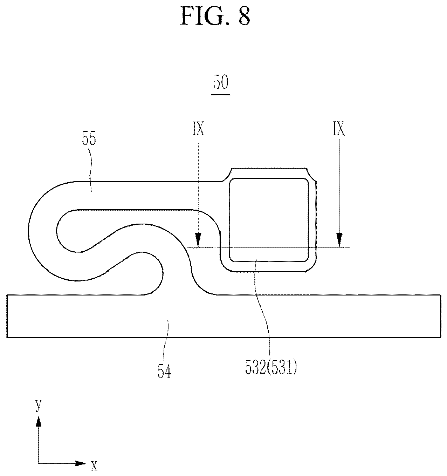

FIG. 7 is a top plan view of the busbar, flexible printed circuit, and unit thin film portion in the rechargeable battery module according to a second embodiment of the present disclosure before bending (e.g. folding), and FIG. 8 is a top plan view of the unit thin film portion of FIG. 7 in a completed state of bending (e.g. folding). Referring to FIGS. 7 and 8, in the second embodiment, there are two unit thin film portions of a flexible printed circuit 50 that are connected in the second direction (y-axis direction).

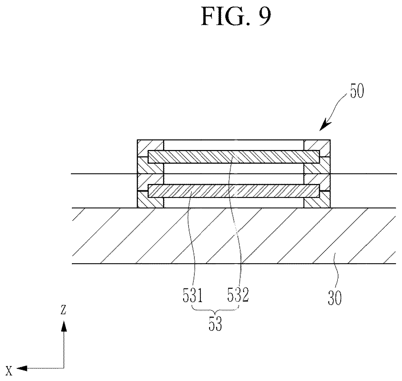

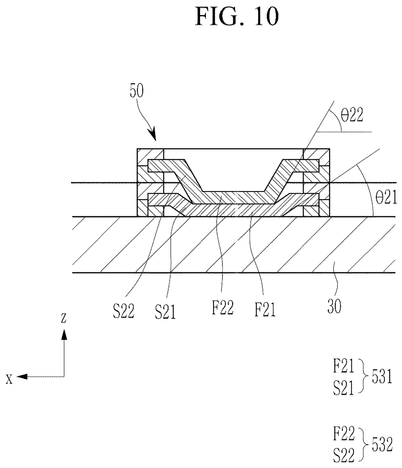

FIG. 9 is a cross-sectional view taken along line IX-IX of the unit thin film portions of FIG. 8 bent (folded) over each other and arranged on a busbar, and FIG. 10 is a cross-sectional view taken along line IX-IX of the unit thin film portions of FIG. 8 welded on a busbar.

Referring to FIGS. 7 to 10, unit thin film portions 53 include a first unit portion 531 and a second unit portion 532 continuously extending along the second direction (y-axis direction). The first unit portion 531 and the second unit portion 532 are bent and overlapped with each other around a first direction bending axis BSx set in the first direction (x-axis direction).

In a welded state, the first unit portion 531 includes a first plane portion F21 connected to a first inclined portion S21 at the first inclined angle θ21, and the second unit portion 532 includes a second plane portion F22 connected to a second inclined portion S22 at a second inclined angle θ22 that is greater than the first inclined angle θ21.

The first plane portion F21 and the second plane portion F22 are connected in the first direction (x-axis direction), are sequentially stacked on the busbar 30, and are welded to the busbar 30. Compared to a one-layer structure, the first plane portion F21 and the second plane portion F22 forming a two-layer structure may effectively prevent piercing and pinhole defects during welding. And the current signal of the bus bar 30 is transmitted to a branch line portion 55 and a main line portion 54 via the first inclined portion S21 and the second inclined portion S22 through the welded first plane portion F21 and the second plane portion F22.

In the flexible printed circuit 50 of the second embodiment, compared to the main line portion 54, the branch line portion 55 and the unit thin film portions 53 generate scrap on both sides of the x-axis direction. The flexible printed circuit 50 of the second embodiment generates more scrap on both sides of the x-axis direction of the second unit portion 532 than the flexible printed circuit 40 of the first embodiment in forming the unit thin film portions 53.

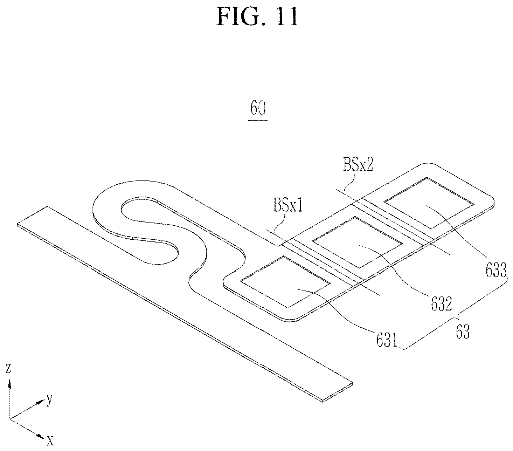

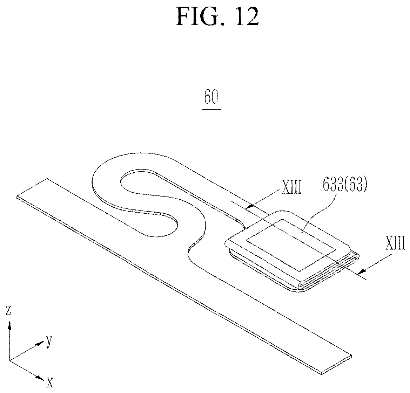

FIG. 11 is a perspective view of the busbar, flexible printed circuit, and unit thin film portion in the rechargeable battery module according to a third embodiment of the present disclosure before bending (e.g. folding), and FIG. 12 is a perspective view of the unit thin film portion of FIG. 11 in a completed state of bending (e.g. folding). Referring to FIGS. 11 and 12, in the third embodiment, the unit thin film portions of a flexible printed circuit 60 are formed of three and connected in the second direction (y-axis direction).

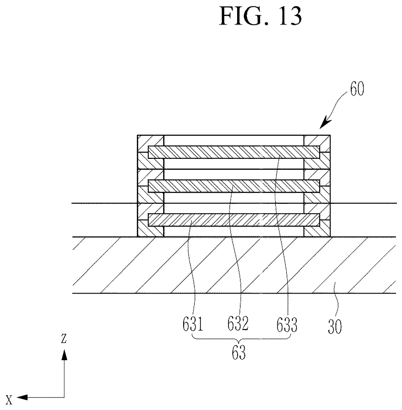

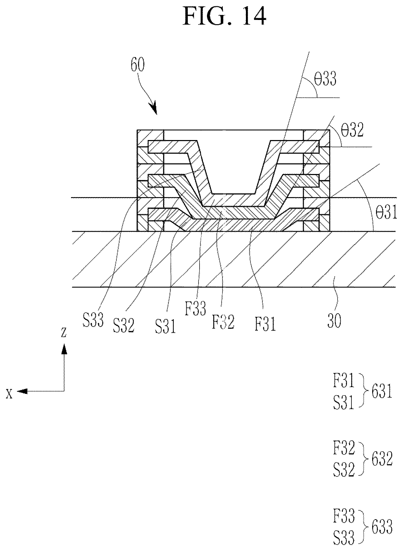

FIG. 13 is a cross-sectional view taken along line XIII-XIII of the unit thin film portions of FIG. 12 bent (folded) over each other and arranged on a busbar, and FIG. 14 is a cross-sectional view taken along line XIII-XIII of the unit thin film portions of FIG. 12 welded on a busbar.

Referring to FIGS. 11 to 14, unit thin film portions 63 include a first unit portion 631, a second unit portion 632, and a third unit portion 633. The first unit portion 631 and the second unit portion 632 are bent and overlapped with each other around a first direction bending axis BSx1 set in the first direction (x-axis direction). The second unit portion 632 and the third unit portion 633 are bent and overlapped with each other around another first direction bending axis BSx2 set in the first direction (x-axis direction).

In a welded state, the first unit portion 631 includes a first plane portion F31 connected to a first inclined portion S31 at a first inclined angle θ31, the second unit portion 632 includes a second plane portion F32 connected to a second inclined portion S32 at a second inclined angle θ32 that is greater than the first inclined angle θ31, and the third unit portion 633 includes a third plane portion F33 connected to a third inclined portion S33 at a third inclined angle θ33 that is greater than the second inclined angle θ32.

The first plane portion F31, the second plane portion F32, and the third plane portion F33 are connected in the second direction (y-axis direction), are sequentially stacked on the busbar 30, and are welded to the busbar 30. Compared to a one-layer structure or a two-layer structure, the first plane portion F31, the second plane portion F32 and the third plane portion F33 forming a three-layer structure may effectively prevent piercing and pinhole defects during welding. And the current signal of the bus bar 30 is transmitted to the branch line portion 55 and a main line portion 54 via the first inclined portion S31, the second inclined portion S32, and the third inclined portion S33 through the welded first plane portion F31, the second plane portion F32, and the third plane portion F33.

In the flexible printed circuit 60 of the third embodiment, the unit thin film portions 63 generate scrap on both sides of the x-axis direction. The flexible printed circuit 60 of the third embodiment generates more scrap on both sides of the x-axis direction of the second unit portion 632 and the third unit portion 633 than the flexible printed circuit 40 of the first embodiment in forming the unit thin film portions 63.

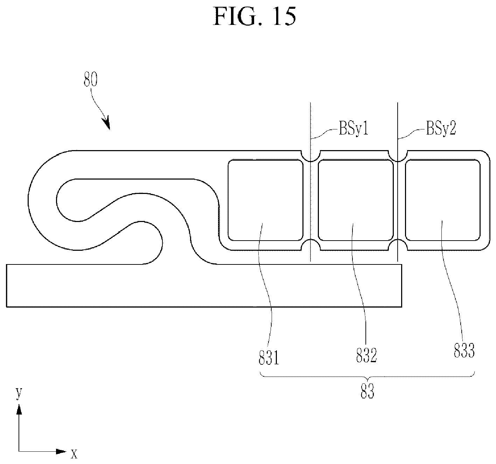

FIG. 15 is a top plan view of the busbar, flexible printed circuit, and unit thin film portion in the rechargeable battery module according to a fourth embodiment of the present disclosure before bending (e.g. folding). Referring to FIG. 15, in the fourth embodiment, the unit thin film portions of a flexible printed circuit 80 are formed of three and connected in the first direction (x-axis direction).

Unit thin film portions 83 include a first unit portion 831, a second unit portion 832 and a third unit portion 833 that continuously extend along the first direction (x-axis direction). The first unit portion 831 and the second unit portion 832 are bent and overlapped with each other around a second direction bending axis BSy1 set in the second direction (y-axis direction). The second unit portion 832 and the third unit portion 833 are bent and overlapped with each other around another second direction bending axis BSy2 set in the second direction (y-axis direction).

Compared to a one-layer structure or a two-layer structure, the first plane portion 831, the second plane portion 832 and the third plane portion 833 forming a three-layer structure may effectively prevent piercing and pinhole defects during welding.

In the flexible printed circuit 80 of the fourth embodiment, the unit thin film portions 83 generate scrap on both sides of the x-axis direction. The flexible printed circuit 80 of the fourth embodiment, in forming the unit film portions 83, compared to the flexible printed circuit 40 of the first embodiment, generates less scrap on both sides in the x-axis direction because the flexible printed circuit 80 further includes the second unit portion 832 and the third unit portion 833.

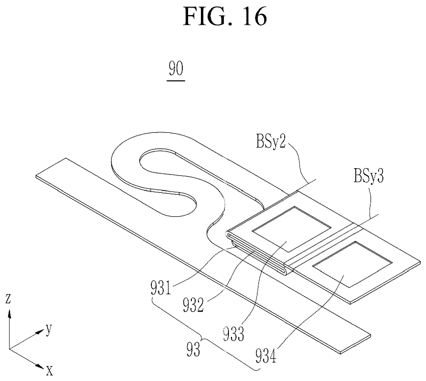

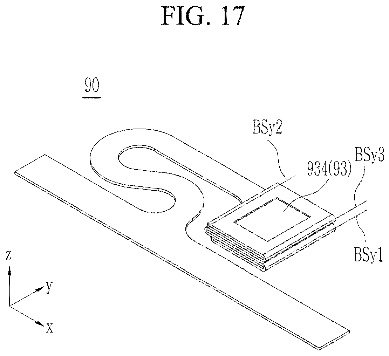

FIG. 16 is a perspective view of the primary and secondary bending states of the flexible printed circuit and the unit thin film portion in the rechargeable battery module according to a fifth embodiment of the present disclosure, and FIG. 17 is a perspective view of the unit thin film portion of FIG. 16 in the tertiary bending state of bending, which corresponds to a complete state of bending (e.g. folding). Referring to FIGS. 16 and 17, in the fifth embodiment, the unit thin film portions of a flexible printed circuit 90 are formed of four and connected in the first direction (x-axis direction).

Unit thin film portions 93 include a first unit portion 931, a second unit portion 932, a third unit portion 933 and a fourth unit portion 934 that continuously extend along the first direction (x-axis direction). The first unit portion 931 and the second unit portion 932 are bent and overlapped with each other around the second direction bending axis BSy1 set in the second direction (y-axis direction). The second unit portion 932 and the third unit portion 933 are bent and overlapped with each other around another second direction bending axis BSy2 set in the second direction (y-axis direction). The third unit portion 933 and the fourth unit portion 934 are bent and overlapped with each other around the other second direction bending axis BSy3 set in the second direction (y-axis direction).

Compared to a one-layer structure, a two-layer structure or a three-layer structure, the first plane portion 931, the second plane portion 932, the third plane portion 933 and the fourth unit portion 934 forming a four-layer structure may effectively prevent piercing and pinhole defects during welding.

In the flexible printed circuit 90 of the fifth embodiment, the unit thin film portions 93 generate scrap on both sides of the x-axis direction. The flexible printed circuit 90 of the fifth embodiment, in forming the unit film portions 93, compared to the flexible printed circuit 40 of the first embodiment, generates less scrap on both sides in the x-axis direction because the flexible printed circuit 90 further includes the second unit portion 932, the third unit portion 933 and the fourth unit portion 934.

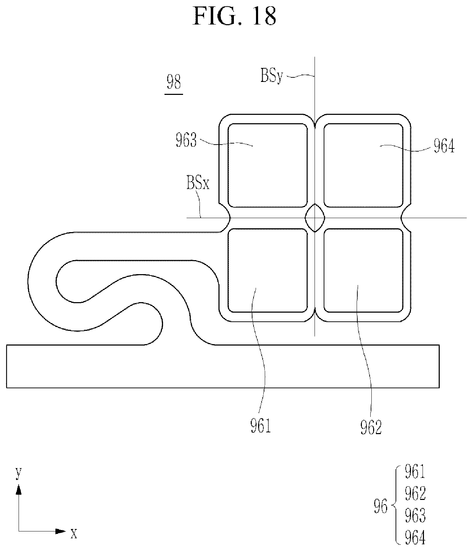

FIG. 18 is a top plan view of the busbar, flexible printed circuit, and unit thin film portion in the rechargeable battery module according to a sixth embodiment of the present disclosure before bending (e.g. folding). Referring to FIG. 18, in the sixth embodiment, the unit thin film portions of a flexible printed circuit 98 are formed of four and connected in the first direction (x-axis direction) and in the second direction (y-axis direction).

Unit thin film portions 96 include a first unit portion 961 and a second unit portion 962 continuously extending along the first direction (x-axis direction), and a third unit portion 963 and a fourth unit portion 964 continuously extending along the second direction (y-axis direction) to the first unit portion 961 and the second unit portion 962, and continuously extending along the first direction (x-axis direction).

The third unit portion 963 and the fourth unit portion 964 are bent around one first direction bending axis BSx set in the first direction (x-axis direction), and are each overlapped with the first unit portion 961 and the second unit portion 962. The fourth unit portion 964 and the second unit portion 962 overlapped with each other are bent around the second direction bending axis BSy set in the second direction (y-axis direction), and are overlapped with the first unit portion 961 and the third unit portion 963, which are overlapped with each other.

Compared to a one-layer structure, a two-layer structure, or a three-layer structure, the first plane portion 961, the second plane portion 962, the third plane portion 963, and the fourth unit portion 964 forming a four-layer structure may effectively prevent piercing and pinhole defects during welding.

In the flexible printed circuit 98 of the sixth embodiment, the unit thin film portions 96 generate scrap on both sides of the x-axis direction. The flexible printed circuit 98 of the sixth embodiment, in forming the unit film portions 96, compared to the flexible printed circuit 40 of the first embodiment, generates less scrap on both sides in the x-axis direction because the flexible printed circuit 98 further includes the second unit portion 962, and generates more scrap on both sides in the x-axis direction because the flexible printed circuit 98 further includes the third unit portion 963 and the fourth unit portion 964.

While this disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

### <Description of symbols>

10: Battery cell
20: Busbar holder
25: Busbar support
30: Busbar
40, 50, 60, 80, 90, 98: Flexible printed circuit (FPC)
41, 42: Cover layer
43, 53, 63, 83, 93, 96: Unit thin film portion
44, 54: Main line
45, 55: Branch line
70: Top cover
411, 421: Opening
431, 531, 631, 831, 931, 961: First unit portion
432, 532, 632, 832, 932, 962: Second unit portion
633, 833, 933, 963: Third unit portion
934, 964: Fourth unit portion
BSx, BSx1, BSx2: First direction bending axis
BSy, BSy1, BSy2, BSy3: Second direction bending axis
F1, F21, F31: First plane portion
F2, F22, F32: Second plane portion
F33: Third plane portion
S1, S21, S31: First inclined portion
S2, S22, S32: Second inclined section
S33: Third inclined portion
θ1, θ21, θ31: First inclined angle
θ2, θ22, θ32: Second inclined angle
θ33: Third inclined angle

## Claims

1. A rechargeable battery module comprising:
a busbar holder (20) covering a plurality of battery cells (10);
a busbar disposed on the busbar holder (20) to electrically connect the battery cells (10); and
a flexible printed circuit (40, 50, 60, 80, 90, 98) attached to the busbar, the flexible printed circuit (40, 50, 60, 80, 90, 98) being configured to send a signal and to detect a current in the busbar, the flexible printed circuit (40, 50, 60, 80, 90, 98) including a thin copper film attached between inner surfaces of a pair of cover layers (41, 42),
wherein the thin copper film is exposed in unit thin film portions (43, 53, 63, 83, 93, 96) through a plurality of openings (411, 421) formed in the pair of cover layers (41, 42),
**characterised in that**
the thin copper film and the pair of cover layers (41, 42) are bent, and
wherein the unit thin film portions (43, 53, 63, 83, 93, 96) form multiple layers and are welded to the busbar.

2. The rechargeable battery module of claim 1, wherein each unit thin film portion has a thickness of 0.035 mm, and
wherein a thickness of the multiple layers is equal to 0.035 mm multiplied by the number of layers.

3. The rechargeable battery module of one of claims 1 or 2, wherein the flexible printed circuit (40, 50, 60, 80, 90, 98) comprises:
a main line portion (44, 54) disposed in a first direction on the busbar holder (20); and
a branch line portion (45, 55) protruding from the main line portion (44, 54) in a second direction intersecting the first direction, and disposed further in the first direction, and
wherein the unit thin film portions (43, 53) are connected to the branch line portion (45, 55).

4. The rechargeable battery module of claim 3, wherein the branch line portion (55) is attached to the busbar.

5. The rechargeable battery module one of claims 3 or 4, wherein the rechargeable battery module has two unit thin film portions (43) connected in the first direction,
wherein the unit thin film portions (43) comprise a first unit portion (431) and a second unit portion (432) continuously extending along the first direction, and
wherein the first unit portion (431) and the second unit portion (432) are bent around a second direction bending axis set in the second direction such that the first unit portion (431) and the second unit portion (432) overlap with each other.

6. The rechargeable battery module of claim 5, wherein the first unit portion (431) comprises a first plane portion (F1) connected to a first inclined portion (S1) at a first inclined angle θ1,
wherein the second unit portion (432) comprises a second plane portion (F2) connected to a second inclined portion (S2) at a second inclined angle θ2 that is greater than the first inclined angle θ1, and
wherein the first plane portion (F1) and the second plane portion (F2) are connected in the second direction, are sequentially stacked on the busbar, and are welded to the busbar.

7. The rechargeable battery module of one of claims 3 or 4, wherein the rechargeable battery module comprise two of the unit thin film portions (53, 63) connected in the second direction,
wherein the unit thin film portions (53, 63) comprise a first unit portion (531, 631) and a second unit portion (532, 632) continuously extending along the second direction, and
wherein the first unit portion (531, 631) and the second unit portion (532, 632) are bent around a first direction bending axis set in the first direction such that the first unit portion (531, 631) and the second unit portion (532, 632) overlap each other.

8. The rechargeable battery module of claim 7, wherein the first unit portion (531, 631) comprises a first plane portion (F21, F31) connected to a first inclined portion (S21, S31) at a first inclined angle θ21,
wherein the second unit portion (532, 632) comprises a second plane portion (F22, F32) connected to a second inclined portion (S22, S32) at a second inclined angle θ22 that is greater than the first inclined angle θ21, and
wherein the first plane portion (F21, F31) and the second plane portion (F22, F32) are connected in the first direction, are sequentially stacked on the busbar, and are welded to the busbar.

9. The rechargeable battery module of one of claims 3 or 4, wherein the rechargeable battery module has three of the unit thin film portions (63) connected in the second direction,
wherein the unit thin film portions (63) comprise a first unit portion (631), a second unit portion (632), and a third unit portion (633) continuously extending along the second direction,
wherein the first unit portion (631) and the second unit portion (632) are bent around a first direction bending axis set in the first direction such that the first unit portion (631) and the second unit portion (632) overlap with each other, and
wherein the second unit portion (632) and the third unit portion (633) are bent around another first direction bending axis set in the first direction such that the second unit portion (632) and the third unit portion (633) overlap with each other.

10. The rechargeable battery module of claim 9, wherein the first unit portion (631) comprises a first plane portion (F31) connected to a first inclined portion (S31) at a first inclined angle θ31,
wherein the second unit portion (632) comprises a second plane portion (F32) connected to a second inclined portion (S32) at a second inclined angle θ32 that is greater than the first inclined angle θ31,
wherein the third unit portion (633) comprises a third plane portion (F33) connected to a third inclined portion (S33) at a third inclined angle θ33 that is greater than the second inclined angle θ32, and
wherein the first plane portion (F31), the second plane portion (F32), and the third plane portion (F33) are connected in the second direction, are sequentially stacked on the busbar, and are welded to the busbar.

11. The rechargeable battery module of one of claims 3 or 4, wherein the rechargeable battery module has three of the unit thin film portions connected in the first direction,
wherein the unit thin film portions comprise a first unit portion (831), a second unit portion (832), and a third unit portion (833) continuously extending along the first direction,
wherein the first unit portion (831) and the second unit portion (832) are bent around a second direction bending axis set in the second direction such that the first unit portion (831) and the second unit portion (832) overlap with each other, and
wherein the second unit portion (832) and the third unit portion (833) are bent around another second direction bending axis set in the second direction such that the second unit portion (832) and the third unit portion (833) overlap with each other.

12. The rechargeable battery module of one of claims 3 or 4, wherein the unit thin film portions (93) comprise a first unit portion (931), a second unit portion (932), a third unit portion (933), and a fourth unit portion (934) continuously extending along the first direction,
wherein the first unit portion (931) and the second unit portion (932) are bent around a second direction bending axis set in the second direction such that the first unit portion (931) and the second unit portion (932) overlap with each other,
wherein the second unit portion (932) and the third unit portion (933) are bent around another second direction bending axis set in the second direction such that the second unit portion (932) and the third unit portion (933) overlap with each other, and
wherein the third unit portion (933) and the fourth unit portion (934) are bent around the other second direction bending axis set in the second direction such that the third unit portion (933) and the fourth unit portion (934) overlap with each other.

13. The rechargeable battery module of one of claims 3 or 4, wherein the rechargeable battery module has four of the unit thin film portions connected in the first direction and the second direction.

14. The rechargeable battery module of claim 13,
wherein the unit thin film portions comprise a first unit portion (961) and a second unit portion (962) continuously extending along the first direction; and
wherein the unit film portions comprise a third unit portion (963) and a fourth unit portion (964) continuously extending along the second direction, connected to the first unit portion (961) and the second unit portion (962), and continuously extending along the first direction.

## Patentansprüche

1. Wiederaufladbares Batteriemodul, umfassend:
einen Busbar-Halter (20), der eine Vielzahl von Batteriezellen (10) abdeckt;
eine an dem Busbar-Halter (20) angeordnete Busbar zum elektrischen Verbinden der Batteriezellen (10); und
eine an der Busbar angebrachte flexible gedruckte Schaltung (40, 50, 60, 80, 90, 98), wobei die flexible gedruckte Schaltung (40, 50, 60, 80, 90, 98) dazu eingerichtet ist, ein Signal zu senden und einen Strom in der Busbar zu detektieren, wobei die flexible gedruckte Schaltung (40, 50, 60, 80, 90, 98) eine Kupferdünnschicht aufweist, die zwischen Innenflächen eines Paars von Deckschichten (41, 42) angebracht ist,
wobei die Kupferdünnschicht in Einheitsdünnschichtabschnitten (43, 53, 63, 83, 93, 96) durch eine Vielzahl von Öffnungen (411, 421), die in dem Paar von Deckschichten (41, 42) ausgebildet sind, freigelegt ist,
**dadurch gekennzeichnet, dass**
die Kupferdünnschicht und das Paar von Deckschichten (41, 42) gebogen sind, und
wobei die Einheitsdünnschichtabschnitte (43, 53, 63, 83, 93, 96) mehrere Schichten bilden und an die Busbar geschweißt sind.

2. Wiederaufladbares Batteriemodul nach Anspruch 1, wobei jeder Einheitsdünnschichtabschnitt eine Dicke von 0,035 mm aufweist, und
wobei eine Dicke der mehreren Schichten gleich 0,035 mm multipliziert mit der Anzahl von Schichten ist.

3. Wiederaufladbares Batteriemodul nach einem der Ansprüche 1 oder 2, wobei die flexible gedruckte Schaltung (40, 50, 60, 80, 90, 98) umfasst:
einen Hauptleitungsabschnitt (44, 54), der in einer ersten Richtung an dem Busbar-Halter (20) angeordnet ist; und
einen Abzweigleitungsabschnitt (45, 55), der von dem Hauptleitungsabschnitt (44, 54) in einer die erste Richtung schneidenden zweiten Richtung vorsteht und weiter in der ersten Richtung angeordnet ist, und
wobei die Einheitsdünnschichtabschnitte (43, 53) mit dem Abzweigleitungsabschnitt (45, 55) verbunden sind.

4. Wiederaufladbares Batteriemodul nach Anspruch 3, wobei der Abzweigleitungsabschnitt (55) an der Busbar angebracht ist.

5. Wiederaufladbares Batteriemodul nach einem der Ansprüche 3 oder 4, wobei das wiederaufladbare Batteriemodul zwei Einheitsdünnschichtabschnitte (43) aufweist, die in der ersten Richtung verbunden sind,
wobei die Einheitsdünnschichtabschnitte (43) einen ersten Einheitsabschnitt (431) und einen zweiten Einheitsabschnitt (432) umfassen, die sich kontinuierlich entlang der ersten Richtung erstrecken, und
wobei der erste Einheitsabschnitt (431) und der zweite Einheitsabschnitt (432) um eine in der zweiten Richtung festgelegte Zweitrichtungs-Biegeachse derart gebogen sind, dass der erste Einheitsabschnitt (431) und der zweite Einheitsabschnitt (432) einander überlappen.

6. Wiederaufladbares Batteriemodul nach Anspruch 5, wobei der erste Einheitsabschnitt (431) einen ersten Ebenenabschnitt (F1) umfasst, der mit einem ersten Neigungsabschnitt (S1) unter einem ersten Neigungswinkel θ1 verbunden ist,
wobei der zweite Einheitsabschnitt (432) einen zweiten Ebenenabschnitt (F2) umfasst, der mit einem zweiten Neigungsabschnitt (S2) unter einem zweiten Neigungswinkel θ2 verbunden ist, der größer als der erste Neigungswinkel θ1 ist, und
wobei der erste Ebenenabschnitt (F1) und der zweite Ebenenabschnitt (F2) in der zweiten Richtung verbunden sind, sequenziell auf der Busbar gestapelt sind und an die Busbar geschweißt sind.

7. Wiederaufladbares Batteriemodul nach einem der Ansprüche 3 oder 4, wobei das wiederaufladbare Batteriemodul zwei der Einheitsdünnschichtabschnitte (53, 63) umfasst, die in der zweiten Richtung verbunden sind,
wobei die Einheitsdünnschichtabschnitte (53, 63) einen ersten Einheitsabschnitt (531, 631) und einen zweiten Einheitsabschnitt (532, 632) umfassen, die sich kontinuierlich entlang der zweiten Richtung erstrecken, und
wobei der erste Einheitsabschnitt (531, 631) und der zweite Einheitsabschnitt (532, 632) um eine in der ersten Richtung festgelegte Erstrichtungs-Biegeachse derart gebogen sind, dass der erste Einheitsabschnitt (531, 631) und der zweite Einheitsabschnitt (532, 632) einander überlappen.

8. Wiederaufladbares Batteriemodul nach Anspruch 7, wobei der erste Einheitsabschnitt (531, 631) einen ersten Ebenenabschnitt (F21, F31) umfasst, der mit einem ersten Neigungsabschnitt (S21, S31) unter einem ersten Neigungswinkel θ21 verbunden ist,
wobei der zweite Einheitsabschnitt (532, 632) einen zweiten Ebenenabschnitt (F22, F32) umfasst, der mit einem zweiten Neigungsabschnitt (S22, S32) unter einem zweiten Neigungswinkel θ22 verbunden ist, der größer als der erste Neigungswinkel θ21 ist, und
wobei der erste Ebenenabschnitt (F21, F31) und der zweite Ebenenabschnitt (F22, F32) in der ersten Richtung verbunden sind, sequenziell auf der Busbar gestapelt sind und an die Busbar geschweißt sind.

9. Wiederaufladbares Batteriemodul nach einem der Ansprüche 3 oder 4, wobei das wiederaufladbare Batteriemodul drei der Einheitsdünnschichtabschnitte (63) aufweist, die in der zweiten Richtung verbunden sind,
wobei die Einheitsdünnschichtabschnitte (63) einen ersten Einheitsabschnitt (631), einen zweiten Einheitsabschnitt (632) und einen dritten Einheitsabschnitt (633) umfassen, die sich kontinuierlich entlang der zweiten Richtung erstrecken,
wobei der erste Einheitsabschnitt (631) und der zweite Einheitsabschnitt (632) um eine in der ersten Richtung festgelegte Erstrichtungs-Biegeachse derart gebogen sind, dass der erste Einheitsabschnitt (631) und der zweite Einheitsabschnitt (632) einander überlappen, und
wobei der zweite Einheitsabschnitt (632) und der dritte Einheitsabschnitt (633) um eine weitere in der ersten Richtung festgelegte Erstrichtungs-Biegeachse derart gebogen sind, dass der zweite Einheitsabschnitt (632) und der dritte Einheitsabschnitt (633) einander überlappen.

10. Wiederaufladbares Batteriemodul nach Anspruch 9, wobei der erste Einheitsabschnitt (631) einen ersten Ebenenabschnitt (F31) umfasst, der mit einem ersten Neigungsabschnitt (S31) unter einem ersten Neigungswinkel θ31 verbunden ist,
wobei der zweite Einheitsabschnitt (632) einen zweiten Ebenenabschnitt (F32) umfasst, der mit einem zweiten Neigungsabschnitt (S32) unter einem zweiten Neigungswinkel θ32 verbunden ist, der größer als der erste Neigungswinkel θ31 ist,
wobei der dritte Einheitsabschnitt (633) einen dritten Ebenenabschnitt (F33) umfasst, der mit einem dritten Neigungsabschnitt (S33) unter einem dritten Neigungswinkel θ33 verbunden ist, der größer als der zweite Neigungswinkel θ32 ist, und
wobei der erste Ebenenabschnitt (F31), der zweite Ebenenabschnitt (F32) und der dritte Ebenenabschnitt (F33) in der zweiten Richtung verbunden sind, sequenziell auf der Busbar gestapelt sind und an die Busbar geschweißt sind.

11. Wiederaufladbares Batteriemodul nach einem der Ansprüche 3 oder 4, wobei das wiederaufladbare Batteriemodul drei der Einheitsdünnschichtabschnitte aufweist, die in der ersten Richtung verbunden sind,
wobei die Einheitsdünnschichtabschnitte einen ersten Einheitsabschnitt (831), einen zweiten Einheitsabschnitt (832) und einen dritten Einheitsabschnitt (833) umfassen, die sich kontinuierlich entlang der ersten Richtung erstrecken,
wobei der erste Einheitsabschnitt (831) und der zweite Einheitsabschnitt (832) um eine in der zweiten Richtung festgelegte Zweitrichtungs-Biegeachse derart gebogen sind, dass der erste Einheitsabschnitt (831) und der zweite Einheitsabschnitt (832) einander überlappen, und
wobei der zweite Einheitsabschnitt (832) und der dritte Einheitsabschnitt (833) um eine weitere in der zweiten Richtung festgelegte Zweitrichtungs-Biegeachse derart gebogen sind, dass der zweite Einheitsabschnitt (832) und der dritte Einheitsabschnitt (833) einander überlappen.

12. Wiederaufladbares Batteriemodul nach einem der Ansprüche 3 oder 4, wobei die Einheitsdünnschichtabschnitte (93) einen ersten Einheitsabschnitt (931), einen zweiten Einheitsabschnitt (932), einen dritten Einheitsabschnitt (933) und einen vierten Einheitsabschnitt (934) umfassen, die sich kontinuierlich entlang der ersten Richtung erstrecken,
wobei der erste Einheitsabschnitt (931) und der zweite Einheitsabschnitt (932) um eine in der zweiten Richtung festgelegte Zweitrichtungs-Biegeachse derart gebogen sind, dass der erste Einheitsabschnitt (931) und der zweite Einheitsabschnitt (932) einander überlappen,
wobei der zweite Einheitsabschnitt (932) und der dritte Einheitsabschnitt (933) um eine weitere in der zweiten Richtung festgelegte Zweitrichtungs-Biegeachse derart gebogen sind, dass der zweite Einheitsabschnitt (932) und der dritte Einheitsabschnitt (933) einander überlappen, und
wobei der dritte Einheitsabschnitt (933) und der vierte Einheitsabschnitt (934) um die andere in der zweiten Richtung festgelegte Zweitrichtungs-Biegeachse derart gebogen sind, dass der dritte Einheitsabschnitt (933) und der vierte Einheitsabschnitt (934) einander überlappen.

13. Wiederaufladbares Batteriemodul nach einem der Ansprüche 3 oder 4, wobei das wiederaufladbare Batteriemodul vier der Einheitsdünnschichtabschnitte aufweist, die in der ersten Richtung und der zweiten Richtung verbunden sind.

14. Wiederaufladbares Batteriemodul nach Anspruch 13,
wobei die Einheitsdünnschichtabschnitte einen ersten Einheitsabschnitt (961) und einen zweiten Einheitsabschnitt (962) umfassen, die sich kontinuierlich entlang der ersten Richtung erstrecken; und
wobei die Einheitsdünnschichtabschnitte einen dritten Einheitsabschnitt (963) und einen vierten Einheitsabschnitt (964) umfassen, die sich kontinuierlich entlang der zweiten Richtung erstrecken, mit dem ersten Einheitsabschnitt (961) und dem zweiten Einheitsabschnitt (962) verbunden sind und sich kontinuierlich entlang der ersten Richtung erstrecken.

## Revendications

1. Module de batterie rechargeable comportant :
un support de barre omnibus (20) recouvrant une pluralité d'éléments de batterie (10) ;
une barre omnibus disposée sur le support de barre omnibus (20) pour connecter électriquement les éléments de batterie (10) ; et
un circuit imprimé flexible (40, 50, 60, 80, 90, 98) fixé à la barre omnibus, le circuit imprimé flexible (40, 50, 60, 80, 90, 98) étant configuré pour envoyer un signal et détecter un courant dans la barre omnibus, le circuit imprimé flexible (40, 50, 60, 80, 90, 98) comprenant un film de cuivre mince fixé entre des surfaces internes d'une paire de couches de couverture (41, 42),
dans lequel le film de cuivre mince est exposé dans des parties de film mince unitaires (43, 53, 63, 83, 93, 96) à travers une pluralité d'ouvertures (411, 421) formées dans la paire de couches de couverture (41, 42),
**caractérisé en ce que** le film de cuivre mince et la paire de couches de couverture (41, 42) sont pliés, et
dans lequel les parties de film mince unitaires (43, 53, 63, 83, 93, 96) forment plusieurs couches et sont soudées à la barre omnibus.

2. Module de batterie rechargeable selon la revendication 1, dans lequel chaque partie de film mince unitaire présente une épaisseur de 0,035 mm, et
dans lequel une épaisseur des multiples couches est égale à 0,035 mm multipliés par le nombre de couches.

3. Module de batterie rechargeable selon l'une des revendications 1 ou 2, dans lequel le circuit imprimé flexible (40, 50, 60, 80, 90, 98) comporte :
une partie de ligne principale (44, 54) disposée dans une première direction sur le support de barre omnibus (20) ; et
une partie de ligne de dérivation (45, 55) faisant saillie de la partie de ligne principale (44, 54) dans une deuxième direction croisant la première direction, et disposée plus loin dans la première direction, et
dans lequel les parties de film mince unitaires (43, 53) sont connectées à la partie de ligne de dérivation (45, 55).

4. Module de batterie rechargeable selon la revendication 3, dans lequel la partie de ligne de dérivation (55) est fixée à la barre omnibus.

5. Module de batterie rechargeable selon l'une des revendications 3 ou 4, dans lequel le module de batterie rechargeable présente deux parties de film mince unitaires (43) connectées dans la première direction,
dans lequel les parties de film mince unitaires (43) comportent une première partie unitaire (431) et une deuxième partie unitaire (432) s'étendant en continu le long de la première direction, et
dans lequel la première partie unitaire (431) et la deuxième partie unitaire (432) sont courbées autour d'un axe de courbure de deuxième direction défini dans la deuxième direction de sorte que la première partie unitaire (431) et la deuxième partie unitaire (432) se chevauchent l'une l'autre.

6. Module de batterie rechargeable selon la revendication 5, dans lequel la première partie unitaire (431) comporte une première partie plane (F1) connectée à une première partie inclinée (S1) selon un premier angle incliné θ1,
dans lequel la deuxième partie unitaire (432) comporte une deuxième partie plane (F2) connectée à une deuxième partie inclinée (S2) selon un deuxième angle incliné θ2 qui est supérieur au premier angle incliné θ1, et
dans lequel la première partie plane (F1) et la deuxième partie plane (F2) sont connectées dans la deuxième direction, sont empilées séquentiellement sur la barre omnibus, et sont soudées à la barre omnibus.

7. Module de batterie rechargeable selon l'une des revendications 3 ou 4, dans lequel le module de batterie rechargeable comporte deux des parties de film mince unitaires (53, 63) connectées dans la deuxième direction,
dans lequel les parties de film mince unitaires (53, 63) comportent une première partie unitaire (531, 631) et une deuxième partie unitaire (532, 632) s'étendant en continu le long de la deuxième direction, et
dans lequel la première partie unitaire (531, 631) et la deuxième partie unitaire (532, 632) sont courbées autour d'un axe de courbure de première direction défini dans la première direction de sorte que la première partie unitaire (531, 631) et la deuxième partie unitaire (532, 632) se chevauchent.

8. Module de batterie rechargeable selon la revendication 7, dans lequel la première partie unitaire (531, 631) comporte une première partie plane (F21, F31) connectée à une première partie inclinée (S21, S31) selon un premier angle incliné θ21,
dans lequel la deuxième partie unitaire (532, 632) comporte une deuxième partie plane (F22, F32) connectée à une deuxième partie inclinée (S22, S32) selon un deuxième angle incliné θ22 qui est supérieur au premier angle incliné θ21, et
dans lequel la première partie plane (F21, F31) et la deuxième partie plane (F22, F32) sont connectées dans la première direction, sont empilées séquentiellement sur la barre omnibus, et sont soudées à la barre omnibus.

9. Module de batterie rechargeable selon l'une des revendications 3 ou 4, dans lequel le module de batterie rechargeable présente trois des parties de film mince unitaires (63) connectées dans la deuxième direction,
dans lequel les parties de film mince unitaires (63) comportent une première partie unitaire (631), une deuxième partie unitaire (632) et une troisième partie unitaire (633) s'étendant en continu le long de la deuxième direction,
dans lequel la première partie unitaire (631) et la deuxième partie unitaire (632) sont pliées autour d'un axe de courbure de première direction défini dans la première direction de sorte que la première partie unitaire (631) et la deuxième partie unitaire (632) se chevauchent, et
dans lequel la deuxième partie unitaire (632) et la troisième partie unitaire (633) sont courbées autour d'un autre axe de courbure de première direction défini dans la première direction de sorte que la deuxième partie unitaire (632) et la troisième partie unitaire (633) se chevauchent l'une l'autre.

10. Module de batterie rechargeable selon la revendication 9, dans lequel la première partie unitaire (631) comporte une première partie plane (F31) connectée à une première partie inclinée (S31) selon un premier angle incliné θ31,
dans lequel la deuxième partie unitaire (632) comporte une deuxième partie plane (F32) connectée à une deuxième partie inclinée (S32) selon un deuxième angle incliné θ32 qui est supérieur au premier angle incliné θ31,
dans lequel la troisième partie unitaire (633) comporte une troisième partie plane (F33) connectée à une troisième partie inclinée (S33) selon un troisième angle incliné θ33 qui est supérieur au deuxième angle incliné θ32, et
dans lequel la première partie plane (F31), la deuxième partie plane (F32) et la troisième partie plane (F33) sont connectées dans la deuxième direction, sont empilées séquentiellement sur la barre omnibus et sont soudées à la barre omnibus.

11. Module de batterie rechargeable selon l'une des revendications 3 ou 4, dans lequel le module de batterie rechargeable présente trois des parties de film mince unitaires connectées dans la première direction,
dans lequel les parties de film mince unitaires comportent une première partie unitaire (831), une deuxième partie unitaire (832) et une troisième partie unitaire (833) s'étendant en continu le long de la première direction,
dans lequel la première partie unitaire (831) et la deuxième partie unitaire (832) sont courbées autour d'un axe de courbure de deuxième direction défini dans la deuxième direction de sorte que la première partie unitaire (831) et la deuxième partie unitaire (832) se chevauchent, et
dans lequel la deuxième partie unitaire (832) et la troisième partie unitaire (833) sont courbées autour d'un autre axe de courbure de deuxième direction défini dans la deuxième direction de sorte que la deuxième partie unitaire (832) et la troisième partie unitaire (833) se chevauchent l'une l'autre.

12. Module de batterie rechargeable selon l'une des revendications 3 ou 4, dans lequel les parties de film mince unitaires (93) comportent une première partie unitaire (931), une deuxième partie unitaire (932), une troisième partie unitaire (933) et une quatrième partie unitaire (934) s'étendant en continu le long de la première direction,
dans lequel la première partie unitaire (931) et la deuxième partie unitaire (932) sont courbées autour d'un axe de courbure de deuxième direction défini dans la deuxième direction de sorte que la première partie unitaire (931) et la deuxième partie unitaire (932) se chevauchent,
dans lequel la deuxième partie unitaire (932) et la troisième partie unitaire (933) sont courbées autour d'un autre axe de courbure de deuxième direction défini dans la deuxième direction de sorte que la deuxième partie unitaire (932) et la troisième partie unitaire (933) se chevauchent, et
dans lequel la troisième partie unitaire (933) et la quatrième partie unitaire (934) sont courbées autour de l'autre axe de courbure de deuxième direction défini dans la deuxième direction de sorte que la troisième partie unitaire (933) et la quatrième partie unitaire (934) se chevauchent l'une l'autre.

13. Module de batterie rechargeable selon l'une des revendications 3 ou 4, dans lequel le module de batterie rechargeable présente quatre des parties de film mince unitaires connectées dans la première direction et la deuxième direction.

14. Module de batterie rechargeable selon la revendication 13,
dans lequel les parties de film mince unitaires comportent une première partie unitaire (961) et une deuxième partie unitaire (962) s'étendant en continu le long de la première direction ; et
dans lequel les parties de film unitaires comportent une troisième partie unitaire (963) et une quatrième partie unitaire (964) s'étendant en continu le long de la deuxième direction, connectées à la première partie unitaire (961) et à la deuxième partie unitaire (962), et s'étendant en continu le long de la première direction.
